(19) Europäisches Patentamt
European Patent Office
Office européen des brevets

(11) **EP 1 543 621 B1**

(12) **EUROPÄISCHE PATENTSCHRIFT**

(45) Veröffentlichungstag und Bekanntmachung des Hinweises auf die Patenterteilung:
**08.03.2006   Patentblatt 2006/10**

(21) Anmeldenummer: **03797167.8**

(22) Anmeldetag: **11.08.2003**

(51) Int Cl.:
***H03L 7/093*** *(2006.01)*

(86) Internationale Anmeldenummer:
**PCT/DE2003/002695**

(87) Internationale Veröffentlichungsnummer:
**WO 2004/027997 (01.04.2004 Gazette 2004/14)**

(54) **PHASENREGELKREIS**

PHASE-LOCKED LOOP

BOUCLE A PHASE ASSERVIE

(84) Benannte Vertragsstaaten:
**DE FR GB IT**

(30) Priorität: **12.09.2002   DE 10242364**

(43) Veröffentlichungstag der Anmeldung:
**22.06.2005   Patentblatt 2005/25**

(73) Patentinhaber: **Infineon Technologies AG
81669 München (DE)**

(72) Erfinder: **LI PUMA, Giuseppe
44791 Bochum (DE)**

(74) Vertreter: **Epping - Hermann - Fischer
Patentanwaltsgesellschaft mbH,
Ridlerstrasse 55
80339 München (DE)**

(56) Entgegenhaltungen:
**EP-A- 1 244 215        DE-A- 10 132 799
US-A- 6 163 184        US-A1- 2002 039 050**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 543 621 B1

**Beschreibung**

Die Erfindung betrifft einen Phasenregelkreis für die Frequenzmodulation eines Senders, wie er beispielsweise in einem Mobilfunksystem Verwendung finden kann.

Eine aufwandsarme Realisierung eines Senderkonzeptes für moderne Mobilfunksysteme zur Frequenzmodulation bietet eine $\Sigma\Delta$-Fractional-N-Phasenregelschleife, die im Folgenden auch als $\Sigma\Delta$-Fractional-N-PLL oder auch nur als PLL bezeichnet wird.

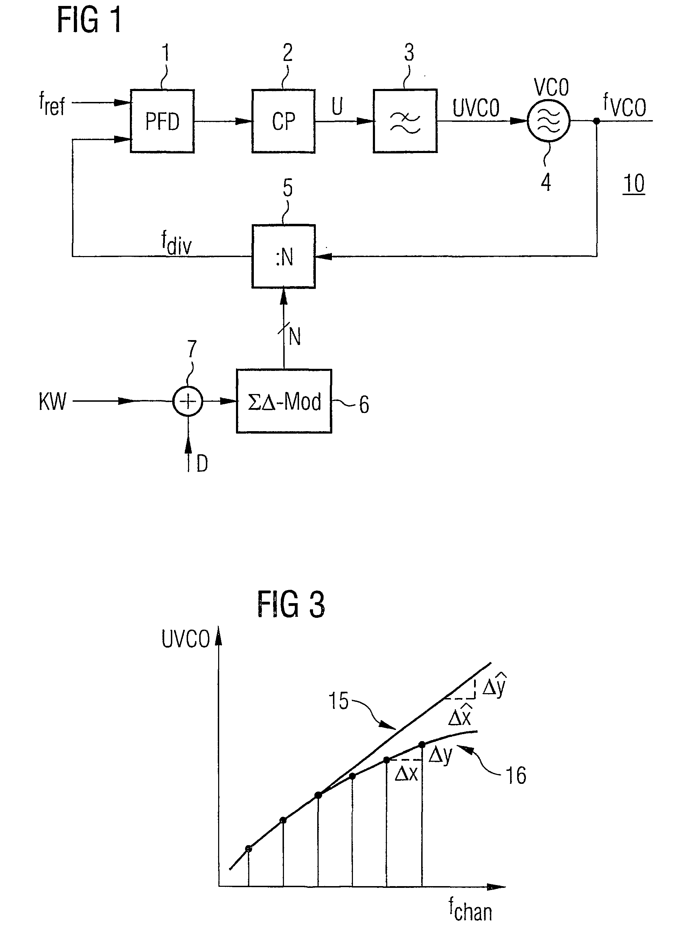

Die PLL 10, wie sie in Figur 1 gezeigt ist, besteht aus einem Phasen-Frequenzdetektor 1, einer Charge-Pump 2, die auch als Ladungspumpe bezeichnet wird, einem Loop-Filter 3, das auch als Schleifenfilter bezeichnet wird, einem spannungsgesteuerten Oszillator 4, kurz VCO, und einem Frequenzteiler 5. An einem Eingang der PLL 10 liegt eine Referenzfrequenz fref an deren Phase mittels dem Phasen-Frequenzdetektor 1 mit einer Phase einer Frequenz fdiv verglichen wird, welche sich aus einer durch einen Teilerwert N geteilten Ausgangsfrequenz fvco ergibt. Gegebenenfalls wird vom Phasen-Frequenzdetektor 1 ein Stellsignal erzeugt und der Ladungspumpe 2 zugeführt, welche davon abhängig eine Spannung U erzeugt, die mittels dem Filter 3 gefiltert als Tuningspannung UVCO am Eingang des spannungsgesteuerten Oszillators 4 anliegt. Dieser wiederum erzeugt die von der Tuningspannung UVCO abhängige Ausgangsfrequenz fvco.

Die gewünschte Frequenzmodulation erfolgt digital über Variation des Frequenzteilerwertes N unter Zuhilfenahme eines $\Sigma\Delta$-Modulators 6. Mittels eines Summieres 7 werden digitale Sendedaten D mit einem Kanalwort KW verknüpft und dem $\Sigma\Delta$-Modulator 6 zugeführt, der dann daraus den Teilerwert N bestimmt und dem Frequenzteiler 5 zur Verfügung stellt. Das Kanalwort KW gibt dabei den Kanal vor.

Bei Verwendung eines nicht integrierenden Schleifenfilters 3 ist die Übertragungsbandbreite der Phasenregelschleife 10 direkt proportional zur VCO-Steilheit Kvco. Die Übertragungsfunktion H(jω) der geschlossenen Regelschleife 10 bestimmt sich zu:

$$H(j\omega) \; = \; \frac{\varphi vco}{\varphi ref} \; = \; \frac{N}{1 + j\omega \, / \, \omega_0} \qquad\qquad (1)$$

wobei
$\phi$vco die Phase am PLL-Ausgang,
$\phi$ref die Phase am PLL-Eingang,
$\omega$ die Kreisfrequenz und
N der Teilerwert ist.

Die Eckfrequenz f0 der -3dB Bandbreite der PLL 10 berechnet sich aus:

$$f0 \; = \; \frac{Kp \, \cdot \, R \, \cdot \, Kvco}{N} \qquad\qquad (2)$$

wobei
Kp die Phasendetektorsteilheit,
R der Schleifenwiderstand gegen Masse und
Kvco die VCO-Steilheit ist.

Die Phasendetektorsteilheit Kp ist proportional zum Chargepump-Strom Icp.

In dem Dokument US 2002/0039050 AI ist ein Synthesizer mit Ladungspumpe angegeben, bei der der Ladungspumpenstrom bezüglich der Abstimmkurve des VCO kompensiert ist. Dabei wird der Ladungspumpenstrom der Ladungspumpe, die zwischen Phasendetektor und Oszillator geschaltet ist, in Abhängigkeit von der Größe eines Frequenzsteuersignals am Eingang des spannungsgesteuerten Oszillators angepasst.

Bisher ist aus dem Stand der Technik keine PLL bekannt, mit der die Gleichspannungsleerlaufverstärkung bzw. Grenzfrequenz über alle Kanäle und über alle Toleranzen fest einstellbar ist.

Eine Aufgabe der Erfindung ist es, einen Phasenregelkreis anzugeben, bei dem eine konstante DC-Leerlaufverstärkung bzw. Grenzfrequenz über alle Kanäle und über alle Toleranzen fest einstellbar ist.

Vorteilhafter Weise bietet die Erfindung die Möglichkeit, die VCO-Steilheit abgleichen zu können.

Die Aufgabe wird durch einen Phasenregelkreis mit den in Patentanspruch 1 angegebenen Merkmalen gelöst.

Der erfindungsgemäße Phasenregelkreis weist eine einstellbare Ladungspumpe zur Erzeugung einer Steuerspannung auf. Dieser ist ein spannungsgesteuerter Oszillator und eine Auswerteeinheit nachgeschaltet. Die Auswerteeinheit ist dabei derart ausgebildet, dass damit anhand der Steuerspannung und einer Sollsteilheit des spannungsgesteuerten Oszillators ein Korrektursignal erzeugbar und am Auswerteausgang anlegbar ist. Dieser wiederum ist mit einem Eingang der Ladungspumpe verbunden.

Vorteilhafte Weiterbildungen der Erfindung ergeben sich den in den abhängigen Patentansprüchen angegebenen Merkmalen.

Bei der Erfindung ist die Auswerteeinheit derart ausgebildet, daß damit der Fehler der Steilheit des spannungsgesteuerten Oszillators berechenbar ist.

Bei dem erfindungsgemäßen Phasenregelkreis ist der Auswerteeinheit ein Analog-Digital-Wandler zum Wandeln der Steuerspannung in ein digitales Wort vorgeschaltet.

Bei der Erfindung ist zwischen die Auswerteeinheit und den Analog-Digital-Wandler ein Register zum Speichern des digitalen Worts geschaltet.

Zwischen die Auswerteeinheit und das Register ist ein Tabellenspeicher geschaltet, um aus dem digitalen Wort und einem Kanalwort den Istwert der Steilheit des spannungsgesteuerten Oszillators zu ermitteln.

Weiterhin kann die Auswerteeinheit eine Recheneinheit aufweisen, um aus dem Istwert der Steilheit des spannungsgesteuerten Oszillators, dem Kanalwort und der Sollsteilheit des spannungsgesteuerten Oszillators einen Steilheitsfehler zu errechnen.

Bei einer weiteren Ausführungsform des erfindungsgemäßen Phasenregelkreises sind der Auswerteeinheit mehrere Register nachgeschaltet, um für mehrere Kanalgruppen jeweils einen Steilheitsfehler zu speichern.

Vorteilhafter Weise ist der Auswerteeinheit eine steuerbare Stromquelle nachgeschaltet, um aus dem Steilheitsfehler das Korrektursignal zu erzeugen.

Zudem kann bei dem erfindungsgemäßen Phasenregelkreis ein Schleifenfilter vorgesehen sein, welches zwischen die Ladungspumpe und den spannungsgesteuerten Oszillator geschaltet ist.

Des weiteren kann bei der Erfindung im Rückkopplungszweig ein Teiler vorgesehen sein.

Schließlich kann in einer weiteren vorteilhaften Ausgestaltung der Erfindung der Teiler einen einstellbaren Teilerwert aufweisen, welcher mit einem $\Sigma\Delta$-Modulator einstellbaren ist.

Im folgenden wird die Erfindung anhand von vier Figuren an mehreren Ausführungsbeispielen weiter erläutert.

Es zeigen:

Figur 1 einen Phasenregelkreis wie er aus dem Stand der Technik bekannt ist,

Figur 2 in Form eines Blockschaltbilds den prinzipiellen Aufbau einer ersten Ausführungsform des Phasenregelkreises gemäß der Erfindung,

Figur 3 ein Frequenzdiagramm mit dem Verlauf der Steilheit eines spannungsgesteuerten Oszillators in Abhängigkeit von der Frequenz und

Figur 4 in Form eines Blockschaltbilds den prinzipiellen Aufbau einer zweiten Ausführungsform des Phasenregelkreises gemäß der Erfindung.

Wie aus der Formel (2) für die Eckfreqeunz bzw. die Bandbreite zu ersehen ist, ist die Grenzfrequenz proportional zu:

$$\mathtt{Icp*R*Kvco/N} \hspace{5cm} (3)$$

und auch proportional zur Ringverstärkung RV. Das Produkt Icp*R legt den Aussteuerbereich des VCOs 4 fest und lässt sich auf Grund der Begrenzung durch die Versorgungsspannung nicht beliebig variieren. Eine Möglichkeit die PLL-Bandbreite bzw. die DC-Ringverstärkung RV einzustellen, liegt in der genauen Einstellung der VCO-Steilheit Kvco. Da jedoch die VCO-Steilheit Kvco aufgrund von Prozessschwankungen variiert, muss ein Abgleichverfahren sicherstellen, dass die Grenzfrequenz f0 konstant bleibt. Das Produkt Icp*R ist nahezu unabhängig gegenüber Technologieschwankungen und damit konstant, sofern der Strom Icp vom gleichen Widerstandstyp abgeleitet wird.

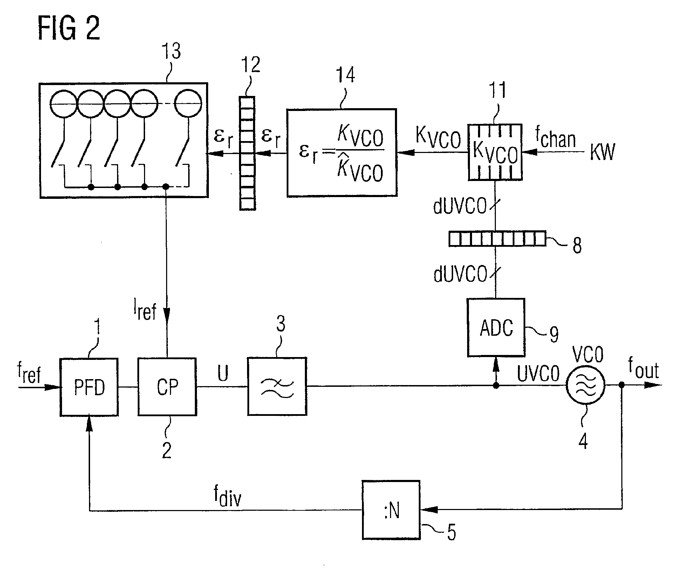

In Figur 2 ist der prinzipielle Aufbau einer ersten Ausführungsform des erfindungsgemäßen Phasenregelkreises gezeigt. Am ersten Eingang des Phasen-Frequenzdetektors 1 liegt die Referenzfrequenz fref an. Am zweiten Eingang des Phasen-Frequenzdetektors 1 liegt die durch den Teilerwert N geteilte Ausgangsfrequenz fout an, welche mit fdiv bezeichnet ist. Falls die Phase der durch den Teilerwert N geteilten Frequenz fdiv von der Phase der Referenzfrequenz fref abweicht, erzeugt der Phasen-Frequenzdetektor 1 ein Steuersignal, um mittels der Ladungspumpe 2 eine korrigierte Ausgangsspannung U zu erzeugen. Die Ausgangsspannung U wird mit dem Tiefpassfilter 3 gefiltert und als Tuningspannung UVCO sowohl auf den Eingang des spannungsgesteuerten Oszillators 4 als auch auf den Eingang eines Analog-DigitalWandlers 9 geführt. Der spannungsgesteuerte Oszillator 4 erzeugt daraufhin eine an die Tuningspannung UVCO angepasste Ausgangsfrequenz fout. Die Tuningspannung UVCO wird mittels dem Analog-Digital-Wandler 9 in ein digitales Wort dUVCO gewandelt. Der Analog-Digital-Wandler 9 ist ausgangsseitig mit einem Register 8, welches das digitale Wort dUVCO zwischenspeichert, verbunden. Dem Register 8 ist wiederum ein Tabellenspeicher 11 nachgeschaltet. Anhand des digitalen Worts dUVCO und eines ebenfalls auf den Tabellenspeicher 11 geführten Kanalworts KW wird aus der im Tabellenspeicher 11 gespeicherten Tabelle die tatsächliche Steilheit Kvco des VCO 4 ermittelt. Die Steilheit Kvco des VCO 4 wird einer Auswerteeinheit 14 zugeführt, die daraus zusammen mit einer Sollsteilheit $\hat{K}$ vco einen Steilheitsfehler εr berechnet und diesen in einem weiteren Register 12 speichert. Mittels einer programmierbaren Stromquelle 13 wird der Steilheitsfehler εr einen Referenzstrom Iref umgewandelt. Die Ladungspumpe 2, welche eingangsseitig zum einen mit dem Phasen-Frequenzdetektor 1 und zum anderen mit dem Ausgang der programmierbaren Stromquelle 13 verbunden ist, ermittelt nun aus dem vom Phasen-Frequenz-Detektor 1 stammenden Stellsignal und dem Referenzstrom Iref eine entsprechende Ausgangsspannung U.

Die Ermittlung des Teilerwerts N kann, ohne dass dies explizit in Figur 2 gezeigt ist, ebenso wie bei der Ausführungsform der PLL 10 in Figur 1, mit Hilfe des ΣΔ-Modulators 6, dem Summierer 7, dem Kanalwort KW und dem digitalen Datensignal D erfolgen.

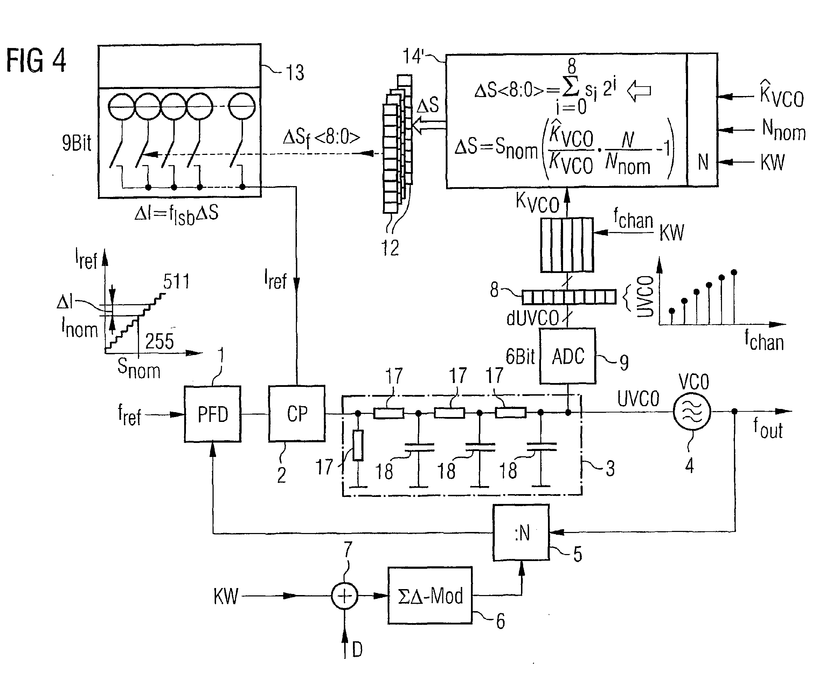

In Figur 3 ist ein Frequenzdiagramm dargestellt, bei dem auf der x-Achse die Kanalfrequenz fchan und auf der y-Achse die Tuningspannung UVCO aufgetragen ist. Mit dem Bezugszeichen 15 ist die ideale Tuningkennlinie und mit dem Bezugszeichen 16 die gemessene Tuningkennlinie bezeichnet. Die Steigung der idealen Tuningkennlinie 15 entspricht dem Sollwert der Steilheit $\hat{K}$ vco des VCO 4 und errechnet sich aus:

$$\hat{K}vco = \frac{\Delta\hat{y}}{\Delta\hat{x}} \tag{4}$$

Die Steigung der gemessenen Tuningkennlinie 16 entspricht dem Istwert der Steilheit Kvco des VCO 4 und errechnet sich aus:

$$Kvco = \frac{\Delta y}{\Delta x} \tag{5}$$

Es ist zu erkennen, daß der Istwert der Steilheit Kvco zunehmender Frequenz abnimmt. Aus der Abweichung des Istwerts Kvco der Steilheit vom Sollwert der Steilheit $\hat{K}$ vco ergibt sich der relative Steilheitsfehler εr zu:

$$\varepsilon r = \frac{Kvco}{\hat{K}vco} \tag{6}$$

In Figur 4 ist eine zweite Ausführungsform des erfindungsgemäßen Phasenregelkreises in Form eines Blockschaltbilds dargestellt. Dabei wird das Tiefpassfilter 3 durch die Verknüpfung von Widerständen 17 und Kondensatoren 18 gebildet.

Die Auswerteeinheit 14, wie sie in Figur 2 gezeigt ist, ist durch eine modifizierte Auswerteeinheit 14' ersetzt. Anhand der Parameter ΔS, welche für jede Kanalfrequenz fchan bzw. Kanalwort KW anhand der Formel:

$$\Delta S = Snom \cdot \left( \frac{\hat{K}vco}{Kvco} \cdot \frac{N}{Nnom} - 1 \right) \qquad (7)$$

berechnet und in den Registerbänken 12 zwischengespeichert werden, wird die programmierbare Stromquelle 13 gesteuert.

Der Referenzstrom Iref kann, wie in dem in Figur 4 links dargestellten Diagramm gezeigt ist, 511 verschiedene Werte annehmen, falls die Referenzstromquelle 13 mit einer Auflösung von 9 Bit arbeitet. Bei einem Wert Snom = 255 ist der Referenzstrom Iref = Inom. Die Änderung des Referenzstroms $\Delta I$ ergibt sich aus:

$$\Delta I = Ilsb * \Delta S \qquad (8)$$

wobei Ilsb die minimal mögliche Änderung des Referenzstroms Iref ist. Ilsb ergibt sich aus der Auflösungsgenauigkeit der programmierbaren Stromquelle 13.

Im Folgenden wird die Funktionsweise der Erfindung noch näher beschrieben. In einem ersten Vorgang erfolgt das Einschwingen der PLL auf einen bestimmten Kanal, der durch das Kanalwort KW vorgegeben wird. Nach der sogenannten Settling-Time der PLL wandelt der Analog-Digital-Umsetzer 9 die Abstimmspannung UVCO des VCOs 4 in ein digitales Wort dUVCO um, das im Register 8 gespeichert wird. Dieser Vorgang wird anschließend für mehrere Frequenzkanäle durchgeführt, so dass aus dem Kanalwort KW, das der eingestellten Kanalfrequenz fchan entspricht, und den amplitudendiskretisierten Werten dUVCO der Tuningspannung UVCO die Abstimmsteilheit Kvco des VCOs 4 berechnet werden kann. Da der Sollwert der VCO-Steilheit $\hat{K}$ vco a priori bekannt ist, siehe Figur 3, kann der relative Fehler $\varepsilon r$, wie bereits oben in Gleichung (6) angegeben, berechnet werden zu:

$$\varepsilon r = \frac{Kvco}{\hat{K}vco} \qquad (6)$$

Zur Kompensation des Fehlers $\varepsilon r$ wird der digital einstellbare Referenzstrom Iref der Ladungspumpe 2 entsprechend des resultierenden Fehlers er verändert. Hierbei muss entsprechend des eingestellten Kanals die Änderung des Teilerwertes N mit berücksichtigt und kompensiert werden. Dies kann jedoch mit Hilfe des Kanalwortes KW, das die Information des Teilerwertes N enthält, erfolgen. Damit dieser Abgleichvorgang bei Anwendung in einem time division multiple access (TDMA) System, wie z.B. Digital European Cordless Telephone (DECT), WDCT oder Bluetooth nicht vor jedem Slot oder Zeitschlitz geschehen muss, kann dieser Vorgang einmalig nach dem Einschalten des Gerätes, beispielsweise innerhalb der Reset-Task, erfolgen. Der Vorgang kann nacheinander für bestimmte Kanalgruppen erfolgen. Die Ansteuerbits für den digital einstellbaren Referenzstrom Iref werden für die verschiedenen Kanäle bzw. Kanalgruppen im Register 12 abgelegt, so dass im normalen Betrieb nach erfolgter Programmierung des Kanalwortes KW die entsprechenden Referenzstromwerte Iref aus den Registern 12 gelesen werden können.

Die erfindungsgemäße Lösung bietet eine einfache Realisierung für den Abgleich der PLL-Ringverstärkung RV:

$$RV \approx \frac{Icp \cdot R \cdot Kvco}{N} \qquad (9)$$

Aufgrund der nichtlinearen VCO-Kennlinie sowie der Variation des Teilerfaktors N über die Kanäle variiert die Ringverstärkung RV und damit die Grenzfrequenz der Phasenregelschleife. Aufgrund der Art und Weise wie die VCO-Abstimmkennlinie bzw. Steilheit Kvco bestimmt, digitalisiert und anschließend durch Änderung des Chargepump-Referenzstromes Iref kompensiert wird, gelingt es, eine nahezu konstante PLL-Ringverstärkung RV bzw. Grenzfrequenz einzustellen.

Bei dem Ausführungsbeispiel in Figur 4 besitzt der VCO 4 eine typische Abstimmsteilheit von 60 MHz. Der digital programmierbare Referenzstrom ist über 9 Bit einstellbar, so dass sich bei nominellen Strom Inom, was dem Dezimalwert 255 entspricht, eine Auflösung von 0,4 % ergibt. Der Wert der Tuningspannung UVCO wird mit dem Analog-Digital-Wandler 9 mit 6 Bit digitalisiert, was einer maximalen Auflösung von 1,5 % entspricht. Die Auswerteeinheit 14' erhält die Sollwerte für den Teilerfaktor Nnom und der VCO-Steilheit $\hat{K}$ vco als Eingangsparameter sowie das Kanalwort KW zur Ermittlung des aktuellen Teilerwertes N.

Bezugszeichenliste

| | |
|---|---|
| 1 | Phasen-Frequenzdetektor |
| 2 | Ladungspumpe |
| 3 | Schleifenfilter |
| 4 | VCO |
| 5 | Frequenzteiler |
| 6 | $\Sigma\Delta$-Modulator |
| 7 | Summierer |
| 8 | Register |
| 9 | Analog-Digital-Wandler |
| 10 | PLL |
| 11 | Tabellenspeicher |
| 12 | Registerbank |
| 13 | Stromquelle |
| 14 | Auswerteeinheit |
| 14' | modifizierte Auswerteeinheit |
| 15 | ideale Tuningspannung |
| 16 | gemessene Tuningspannung |
| 17 | Widerstand |
| 18 | Kondensator |
| N | Teilerwert |
| U | Ausgangsspannung der Ladungspumpe |
| KW | Kanalwort |
| D | digitale Signaldaten |
| UCVO | Tuningspannung |
| dUCVO | digitalisierte Tuningspannung |
| fout | Ausgangsfrequenz |
| fref | Referenzfrequenz |
| Iref | Referenzstrom |
| fchan | Kanalfrequenz |

**Patentansprüche**

1. Phasenregelkreis,
   mit einer einstellbaren Ladungspumpe (2) zur Erzeugung einer Steuerspannung (UVCO), der ein spannungsgesteuerter Oszillator (4) und eine Auswerteeinheit (14; 14') nachgeschaltet sind, wobei die einen Auswerteausgang aufweisende Auswerteeinheit (14; 14') derart ausgebildet ist, dass damit anhand der Steuerspannung (UVCO) und einer Sollsteilheit ($\hat{K}$ vco) des spannungsgesteuerten Oszillators (4) ein Korrektursignal (Iref) erzeugbar und am Auswerteausgang anlegbar ist, und wobei der Auswerteausgang mit einem Ladungspumpeneingang der Ladungspumpe (2) verbunden ist,
   bei dem die Auswerteeinheit (14; 14') derart ausgebildet ist, dass damit ein Steilheitsfehler ($\varepsilon r$; $\Delta S$) des spannungsgesteuerten Oszillators (4) berechenbar ist,
   bei dem der Auswerteeinheit ein Analog-Digital-Wandler (9) zum Wandeln der Steuerspannung (UVCO) in ein digitales Wort (dUVCO) vorgeschaltet ist,
   **dadurch gekennzeichnet, dass** zwischen die Auswerteeinheit (14; 14') und den Analog-Digital-Wandler (9) ein Register (8) zum Speichern des digitalen Wortes (dUVCO) geschaltet ist und
   dass zwischen die Auswerteeinheit (14; 14') und das Register (8) ein Tabellenspeicher (11) geschaltet ist, um aus dem digitalen Wort (dUVCO) und einem Kanalwort (KW) einen Istwert der Steilheit (Kvco) des spannungsgesteuerten Oszillators (4) zu ermitteln.

**2.** Phasenregelkreis nach Patentanspruch 1,
bei dem die Auswerteeinheit (14; 14') eine Recheneinheit aufweist, um aus dem Istwert der Steilheit (Kvco) des spannungsgesteuerten Oszillators (4), dem Kanalwort (KW) und der Sollsteilheit ($\hat{K}$vco) des spannungsgesteuerten Oszillators (4) den Steilheitsfehler ($\varepsilon$r; $\Delta$S) zu errechen.

**3.** Phasenregelkreis nach Patentanspruch 1 oder 2,
bei dem der Auswerteeinheit (14') mehrere Register (12) nachgeschaltet sind, um für mehrere Kanalgruppen jeweils einen Steilheitsfehler ($\Delta$Sf) zu speichern.

**4.** Phasenregelkreis nach einem der Patentansprüche 1 bis 3, bei dem der Auswerteeinheit (14; 14') eine steuerbare Stromquelle (13) nachgeschaltet ist, um aus dem Steilheitsfehler ($\Delta$Sf) das Korrektursignal (Iref) zu erzeugen.

**5.** Phasenregelkreis nach einem der Patentansprüche 1 bis 4, mit einem Schleifenfilter (3), welches zwischen die Ladungspumpe (2) und den spannungsgesteuerten Oszillator (4) geschaltet ist.

**6.** Phasenregelkreis nach einem der Patentansprüche 1 bis 5, mit einem Rückkopplungszweig, in welchem ein Teiler (5) vorgesehen ist.

**7.** Phasenregelkreis nach Patentanspruch 6,
bei dem der Teiler (5) einen einstellbaren Teilerwert (N) aufweist,
mit einem $\Sigma\Delta$-Modulator (6), mit dem der Teilerwert (N) einstellbar ist.

**Claims**

**1.** Phase locked loop,
having an adjustable charge pump (2) which is intended to generate a control voltage (UVCO) and has a voltage-controlled oscillator (4) and an evaluation unit (14; 14') connected downstream of it, the evaluation unit (14; 14'), which has an evaluation output, being designed in such a manner that it can be used to generate a correction signal (Iref) using the control voltage (UVCO) and a nominal gradient ($\hat{K}$vco) of the voltage-controlled oscillator (4) and to apply said signal to the evaluation output, and the evaluation output being connected to a charge pump input of the charge pump (2),
in which the evaluation unit (14; 14') is designed in such a manner that it can be used to calculate a gradient error (er; $\Delta$S) of the voltage-controlled oscillator (4),
in which an analogue/digital converter (9) for converting the control voltage (UVCO) into a digital word (dUVCO) is connected upstream of the evaluation unit,
**characterized in that** a register (8) for storing the digital word (dUVCO) is connected between the evaluation unit (14; 14') and the analogue/digital converter (9), and
**in that** a table memory (11) is connected between the evaluation unit (14; 14') and the register (8) in order to ascertain an actual value of the gradient (Kvco) of the voltage-controlled oscillator (4) using the digital word (dUVCO) and a channel word (KW).

**2.** Phase locked loop according to Patent Claim 1,
in which the evaluation unit (14; 14') has a processing unit in order to calculate the gradient error ($\varepsilon$r; $\Delta$S) from the actual value of the gradient (Kvco) of the voltage-controlled oscillator (4), the channel word (KW) and the nominal gradient ($\hat{K}$vco) of the voltage-controlled oscillator (4).

**3.** Phase locked loop according to Patent Claim 1 or 2,
in which a plurality of registers (12) are connected downstream of the evaluation unit (14') in order to store a respective gradient error ($\Delta$Sf) for a plurality of channel groups.

**4.** Phase locked loop according to one of Patent Claims 1 to 3,
in which a controllable current source (13) is connected downstream of the evaluation unit (14; 14') in order to generate the correction signal (Iref) from the gradient error ($\Delta$Sf).

**5.** Phase locked loop according to one of Patent Claims 1 to 4, having a loop filter (3) which is connected between the charge pump (2) and the voltage-controlled oscillator (4).

**6.** Phase locked loop according to one of Patent Claims 1 to 5, having a feedback path which contains a divider (5).

**7.** Phase locked loop according to Patent Claim 6,
in which the divider (5) has a division value (N) which can be set,
said phase locked loop having a $\Sigma\Delta$ modulator (6) which can be used to set the division value (N).

**Revendications**

**1.** Boucle à phase asservie,
comprenant une pompe (2) à charge réglable pour la production d'une tension (UVCO) de commande, en aval de laquelle sont montés un oscillateur (4) commandé par la tension et une unité (14 ; 14') d'exploitation, l'unité (14 ; 14') d'exploitation ayant une sortie d'exploitation étant constituée de façon à pouvoir produire ainsi, au moyen de la tension (UVCO) de commande et d'une pente (^Kvco) de consigne de l'oscillateur (4) commandé par la tension, un signal (Iref) de correction et à pouvoir l'appliquer à la sortie d'exploitation et la sortie d'exploitation est reliée à une entrée de la pompe (2) à charge,
dans laquelle l'unité (14 ; 14') d'exploitation est constituée de façon à pouvoir ainsi calculer une erreur de pente ($\epsilon$r ; $\Delta$S) de pente de l'oscillateur (4) commandé par la tension,
dans laquelle il est monté en amont de l'unité d'exploitation un convertisseur (9) analogique-numérique de transformation de la tension (UVCO) de commande en un mot (dUVCO) numérique,
**caractérisée en ce qu'**il est monté entre l'unité (14 ; 14') d'exploitation et le convertisseur (9) Analogue-numérique un registre (8) de mémorisation du mot (dUVCO) numérique et
**en ce qu'**il est monté entre l'unité (14 ; 14') d'exploitation et le registre (8) une mémoire (11) de table pour déterminer à partir du mot (dUVCO) numérique et d'un mot (KW) de canal une valeur réelle de pente (Kvco) de l'oscillateur (4) commandé par la tension.

**2.** Boucle asservie en phase suivant la revendication 1,
dans laquelle l'unité (14 ; 14') d'exploitation a une unité de calcul pour calculer, à partir de la valeur réelle de la pente (Kvco), de l'oscillateur (4) commandé par la tension du mot (KW) de canal et de la pente (^Kvco) de consigne de l'oscillateur (4) commandé par la tension, l'erreur ($\epsilon$r ; $\Delta$S) de pente.

**3.** Boucle asservie en phase suivant la revendication 1,
dans laquelle il est monté en aval de l'unité (14') d'exploitation plusieurs registres (12) pour mémoriser pour plusieurs groupes de canaux, respectivement, une erreur ($\Delta$Sf) de pente.

**4.** Boucle asservie en phase suivant l'une des revendications 1 à 3,
dans laquelle il est monté en aval de l'unité (14 ; 14') d'exploitation une source (13) de courant pouvant être commandée pour produire le signal (Iref) de correction à partir de l'erreur ($\Delta$Sf) de pente.

**5.** Boucle asservie en phase suivant l'une des revendications 1 à 4,
comprenant un filtre (3) à boucle qui est monté entre la pompe (2) à charge et l'oscillateur (4) commandé par la tension.

**6.** Boucle asservie en phase suivant l'une des revendications 1 à 5,
ayant une branche de réaction, dans laquelle est prévu un diviseur (5).

**7.** Boucle asservie en phase suivant la revendication 6,
dans laquelle le diviseur (5) a une valeur (N) de division réglable,
comprenant un modulateur (6) $\Sigma\Delta$ par lequel la valeur (N) de division peut être réglée.

# FIG 1

# FIG 3

# FIG 2

$$\varepsilon_r = \frac{K_{VCO}}{\hat{K}_{VCO}}$$

# FIG 4

$$\Delta S<8:0> = \sum_{i=0}^{8} s_i \, 2^i$$

$$\Delta S = S_{nom}\left(\frac{\hat{K}_{VCO}}{K_{VCO}} \cdot \frac{N}{N_{nom}} - 1\right)$$

$$\Delta I = f_{lsb}\Delta S$$

EP 1 543 621 B1